# EUROPÄISCHE PATENTSCHRIFT

(11) **EP 0 393 435 B1**
(45) Veröffentlichungstag und Bekanntmachung des Hinweises auf die Patenterteilung: **03.01.1996**
(21) Anmeldenummer: 90106588.8
(22) Anmeldetag: 06.04.1990
(51) Int. Cl.: G11C 11/412

(54) **Statische Speicherzelle**
Static memory cell
Cellule de mémoire statique

(30) Priorität: 21.04.1989 DE 3913210
(43) Veröffentlichungstag der Anmeldung: 24.10.1990
(73) Patentinhaber: SIEMENS AKTIENGESELLSCHAFT, D-80333 München (DE)
(72) Erfinder: Mattausch, Hans-Jürgen, Dr. rer. nat., D-8011 Brunnthal-Faistenhaar (DE); Hoppe, Bernhard, Dr. rer. nat./bei Dr.W.Krüger, D-6000 Frankfurt 1 (DE); Neuendorf, Gerd, Dipl.-Ing., D-8034 Germering (DE); Schmitt-Landsiedel, Doris, Dr. rer. nat., D-8012 Ottobrunn (DE); Pfleiderer, Hans-Jörg, Prof.-Dr.-Ing., D-8011 Zorneding (DE); Wurm, Maria, D-8011 Ottobrunn (DE)

(56) Entgegenhaltungen:
- EP-A- 224 887
- EP-A- 0 233 968
- US-A- 3 493 786
- ELECTRONICS AND COMMUNICATIONS IN JAPAN. Bd. 63, Nr. 9, September 1980, NEW YORK US Seiten 81 - 90; FUKUDA: '256-BIT ELASTIC STORE CMOS LSI '
- IBM TECHNICAL DISCLOSURE BULLETIN. Bd. 31, Nr.1, Juni 1988, NEW YORK US Seite 291; "COMBINED SINGLE/DUAL-PORT ARRAY APPROACH WITH 6-DEVICE CELL"

## Beschreibung

Die Erfindung betrifft eine statische Speicherzelle nach dem Oberbegriff des Patentanspruches 1.

Die MOS-Speicher zählen zu den integrierten Schaltungen mit einem hohen Integrationsgrad, nach Art ihrer Informationsspeicherung lassen sie sich in folgende Hauptgruppen unterteilen: MOS-Speicher mit dynamischer Informationsspeicherung, MOS-Speicher mit statischer Informationsspeicherung, sowie MOS-Speicher mit nicht flüchtiger Informationsspeicherung. Im vorliegenden Fall ist die mittlere Gruppe der MOS-Speicher, also die statischen Speicher von besonderem Interesse. Hierbei wird die Information, die in die Speicherzelle eingeschrieben wurde, gespeichert, wobei diese ihren einmal gesetzten Zustand solange beibehält, bis die Versorgungsspannung abgeschaltet wird oder aus anderen Gründen nicht mehr an der Speicherzelle anliegt. Der Aufbau statischer Speicherzellen ist mit verschiedenen MOS-Techniken möglich. Als besonders vorteilhaft im bezug auf verlustarme Technik hat sich hierbei die CMOS-Technologie herausgestellt. In der Veröffentlichung von H. Weiß, K. Horninger "Integrierte MOS-Schaltungen", Springer-Verlag 1982, ist auf Seite 229, Bild 4.73c eine typische 6-Transistor-Speicherzelle in CMOS-Technik wiedergegeben. Sie besteht aus einem kreuzgekoppelten Flip-Flop, wobei zwei Auswahltransistoren die Verbindung zwischen den beiden Datenleitungen und den Speicherknoten herstellen. Die 6-Transistor-Speicherzelle wird beim Lesen und Schreiben über die Wortleitung adressiert und an das Datenleitungspaar angeschlossen. Je nachdem, ob der linke Speicherknoten an das Bezugspotential liegt oder auf dem Potential der Versorgungsspannung, ist in der Speicherzelle eine logische "0" oder "1" gespeichert. In beiden Fällen fließt kein Querstrom zwischen der Versorgungsspannung und dem Bezugspotential durch die Speicherzelle, da in den beiden Flip-Flop-Zweigen einer der Transistoren sperrt und der andere leitend geschaltet ist.

Bei Anordnungen dieser Art besteht die Gefahr, daß beim Auslesen einer Speicherzelle deren Zustand durch Ladungsübertrag von dem einen oder anderen Speicherknoten auf die Datenleitungen verändert wird. Daher darf die Weite der Auswahltransistoren nicht zu groß im Verhältnis zu den n-Kanal-Transistoren im Speicher-Flip-Flop gewählt werden. Andererseits muß die Wahl der Auswahltransistoren im Verhältnis zu den p-Kanal-Transistoren im Speicher-Flip-Flop groß genug sein, um das Einschreiben zu ermöglichen. Diese p-Kanal-Transistoren dienen dazu, die Zellinformation statisch zu halten und können mit minimaler Kanalweite dimensioniert werden. Die ursprünglichen Forderungen bei der Dimensionierung der symmetrischen 6-Transistor-Zelle führen dazu, daß zum Entwurf einer solchen Speicherzelle ausführliche Störsignalsicherheitsanalysen insbesondere bezüglich des Einflusses von Technologieschwankungen erforderlich sind. Bestehende Entwürfe müssen bei Änderung der Technologieparameter, beim Umsetzen auf maßstäblich verkleinerte Geometrien (Shrink) und bei Änderung der Versorgungsspannung überprüft und im allgemeinen verändert werden. Die Einschränkung der Weite der Auswahltransistoren begrenzt zudem die erzielbare Geschwindigkeit. Bei üblichen statischen Halbleiterspeichern mit 6-Transistor-Speicherzellen werden häufig die nicht ausgewählten Datenleitungen auf ein festes Potential vorgeladen. Nach einem Schreibzugriff wird das zum Schreiben benutzte Datenleitungspaar zusätzlich über einen Transistor verbunden, um durch Ladungsausgleich zwischen diesen beiden Leitungen die Schreiberholzeit (write recovery time) zu verkürzen. Durch diese Maßnahmen wird die Störsicherheit und die Geschwindigkeit zugleich jedoch auch die Zugriffszeit erhöht. In der genannten Veröffentlichung auf Seite 244 bis 245 ist weiterhin beschrieben, daß zum schnellen Erkennen des Zellsignals beim Einlesen die Datenleitungen im allgemeinen einen Differenzverstärker zugeführt werden. Im Differenzverstärker wird sodann das Entladen einer diesen beiden Datenleitungen erkannt. Die Bewertung erfolgt zu einem Zeitpunkt, an dem die Datenleitungen noch keine logischen Pegel erreicht haben, sondern erst einen Potentialunterschied von wenigen hundert Millivolt aufweisen. Der so erzielte Zeitgewinn wird aber erkauft durch die Verwendung einer Analogschaltung, die eine große Fläche verbraucht und die wie die Speicherzelle gegen technologiebedingte Schwankungen des Arbeitspunktes anfällig ist.

Aus der europäischen Anmeldeschrift mit der Veröffentlichungsnummer 0 233 968 ist ein Gegenstand mit den Merkmalen aus dem Oberbegriff des Patentanspruchs 1 bekannt.

Ferner ist aus der amerikanischen Anmeldeschrift US-A-493 786 bzw. aus der Veröffentlichung ELECTRONICS AND COMMUNICATION IN JAPAN; Band 63, Nr. 9, Sept. 1980, New York, USA, Seiten 81 bis 90, die Verwendung von Transfergates bzw. einer Reihenschaltung von Transfergates anstelle von Transfertransistoren zum Durchschalten von Datenleitungen auf Speicherzellen bekannt.

Der Erfindung liegt die Aufgabe zugrunde, eine verbesserte Schaltung für Speicherzellen in CMOS-Technologie anzugeben, die eine verkürzte Zugriffs- und Schreiberholzeit gegenüber dem Stand der Technik aufweisen die geringe Abmessungen für die periphere Schaltung erfordern und die ein störungsfreies Auslesen der Daten aus der Speicherzelle gewährleistet.

Diese Aufgaben werden erfindungsgemäß durch die im Patentanspruch 1 angegebenen Merkmale gelöst.

Die mit der Erfindung erzielten Vorteile bestehen insbesondere darin, daß die Verwendung von Analogschaltungen, wie beispielsweise analoge Differenzverstärker, vermieden wird und die Störsicherheit gegen Technologieänderungen und Parameterschwankungen durch den Einsatz von erfindungsgemäßen Speicherzellen erhöht wird. Diese Vorteile werden besonders in Verbindung mit kurzen Bitleitungen erzielt, wie dies in kleinen Speichern oder Speichern mit hierarchischer Architektur der Fall ist.

Die Patentansprüche 2 bis 5 sind auf eine bevorzugte Ausgestaltung der Speicherzellen gerichtet, die dort näher erläutert wird.

Die Erfindung wird nachfolgend anhand von Zeichnungen näher beschrieben, es zeigen dabei:
Figur 1 eine Speicherzelle für statische Speicher in CMOS-Technologie nach dem Stand der Technik,
Figur 2 eine erfindungsgemäße 6-Transistor-Speicherzelle mit getrennten Schreib- und Lesewortleitungen und getrennten Schreib- und Lesedatenleitungen,
Figur 3 eine erfindungsgemäße 8-Transistor-Speicherzelle,
Figur 4 eine erfindungsgemäße 7-Transistor-Speicherzelle mit CMOS-Transfergate als Schreibauswahlschaltung,
Figur 5 eine erfindungsgemäße 7-Transistor-Speicherzelle mit zwei in Serie geschalteten Schreibauswahltransistoren und drei Wortleitungen,
Figur 6 eine erfindungsgemäße 7-Transistor-Speicherzelle mit zwei in Serie geschalteten Schreibauswahltransistoren und zwei Wortleitungen.

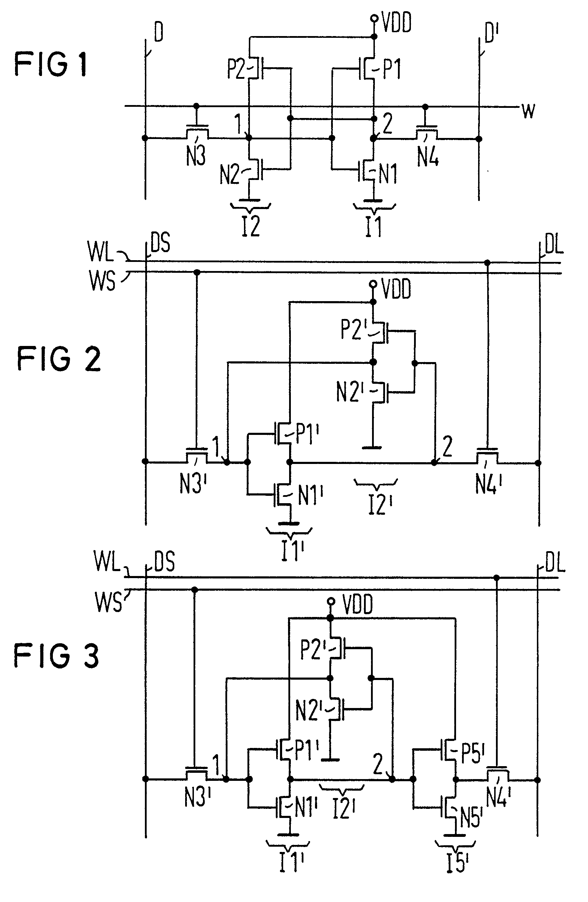

Figur 1 zeigt die Speicherzelle für statische Speicher in Komplementärkanaltechnik (CMOS-Technologie). Sie enthält ein kreuzgekoppeltes Flip-Flop, welches aus den beiden Invertern I1 und I2 gebildet wird. Über die Datenleitung D, D' wird die Information für die Speicherzelle ein- bzw. ausgelesen und über die Wortleitung W die Speicherzelle angesteuert. Wird beim Einlesevorgang zum Beispiel an den Speicherknoten 1 eine Spannung von 0 Volt angelegt, so sperrt der n-Kanal-Feldeffekttransistor N1, während der n-Kanal-Feldeffekttransistor N2 leitet. Am Speicherknoten 1 liegt sodann eine Spannung von 0 Volt, während am Speicherknoten 2 eine Spannung anliegt, die der Versorgungsspannung VDD entspricht. Beim Sperren der Auswahltransistoren N3 und N4 bleibt das Flip-Flop in seinem definierten Zustand und klappt erst beim Anlegen von entgegengesetzten Spannungspegeln auf den Datenleitungen D, D' und bei leitenden Auswahltransistoren N3, N4 in den anderen Zustand um. Ebenso wird durch Feststellen der Potentiale an den Speicherknoten 1 und 2 der Zustand der Speicherzelle gelesen. Durch die Verwendung der Komplementärkanaltechnik wird die Verlustleistung der Speicherzelle so klein wie möglich gehalten. In beiden stabilen Zuständen bleiben entweder nur der n-Kanal-Feldeffekttransistor N1 und der p-Kanal-Feldeffekttransistor P2 oder der p-Kanal-Feldeffekttransistor P1 und der n-Kanal-Feldeffekttransistor N2 geöffnet. Es fließt daher nur bei dem Umschaltvorgang ein Querstrom.

Im einzelnen ist die Speicherzelle nach Figur 1 wie folgt aufgebaut. Der inverter I1 enthält einen n-Kanal-Feldeffekttransistor N1 und einen p-Kanal-Feldeffekttransistor P1, während der zweite Inverter I2 den n-Kanal-Feldeffekttransistor N2 und den p-Kanal-Feldeffekttransistor P2 enthält. Beide p-Kanal-Feldeffekttransistoren P1 und P2 sind mit je einem ersten Anschluß mit der Versorgungsspannung VDD verschaltet, während je ein erster Anschluß der beiden n-Kanal-Feldeffekttransistoren N1 und N2 mit dem Bezugspotential zu verbinden sind. Der Eingang des ersten Inverters I1 wird mit Hilfe der beiden Gateanschlüsse von P1 und N1 gebildet und ist über den n-Kanal-Auswahltransistor N3 mit der Datenleitung D verbunden. Der Ausgang des ersten Inverters I1 wird jeweils mit Hilfe eines zweiten Anschlusses des p-Kanal-Feldeffekttransistors P1 und des n-Kanal-Feldeffekttransistors N1 gebildet und ist über den n-Kanal-Auswahltransistor N4 mit der inversen Datenleitung D' verschaltet. Der zweite Inverter I2 ist hierbei mit seinem aus den beiden Gateanschlüssen von P2 und N2 gebildeten Eingang mit dem Ausgang des Inverters I1 zu verschalten, während der Ausgang von I2, gebildet mit Hilfe des zweiten Anschlusses von P2 und des zweiten Anschlusses von N2, mit dem Eingang des Inverters I1 zu verbinden ist. Zur Speicherung der Informationen enthält die Speicherzelle zwei Speicherknoten 1 und 2, wobei der Speicherknoten 1 aus der leitenden Verbindung zwischen dem Ausgang des Inverters I2 und dem Eingang des Inverters I1 gebildet wird und der Speicherknoten 2 sich aus der leitenden Verbindung zwischen dem Ausgang des Inverters I1 und dem Eingang des Inverters I2 ergibt. Die Wortleitung W ist mit den beiden Gateanschlüssen der Auswahltransistoren N3 und N4 verbunden und aktiviert beide Auswahltransistoren im Falle des Ein- bzw. Auslesens.

Die Transistoren N1 und N2, P1 und P2 sowie N3 und N4 sind paarweise gleich zu dimensionieren. Wie bereits eingangs angegeben darf die Weite der Auswahltransistoren N3 und N4 nicht zu groß im Verhältnis zu den n-Kanal-Transistoren im Speicher-Flip-Flop N1 und N2 gewählt werden. Andererseits muß die Weite der Auswahltransistoren im Verhältnis zu den p-Kanal-Transistoren P1 und P2 groß genug sein um das Einschreiben zu ermöglichen. Hierbei dienen P1 und P2 dazu, die Zellinformation statisch zu erhalten und können mit Minimalweiten dimensioniert werden. Als Beispiel für eine Dimensionierung sei angegeben W (N1) : W (N3) : W (P1) = 1,5 : 1 : 1.

Die Figur 2 zeigt eine erfindungsgemäße 6-Transistor-Speicherzelle mit getrennten Schreib- und Lesewortleitungen und getrennten Schreib- und Lesedatenleitungen. Sie unterscheidet sich in schaltungstechnischer Hinsicht von der in Figur 1 dargestellten Speicherzelle durch das Vorhandensein von zwei Wortleitungen WL und WS zum Lesen bzw. Schreiben sowie durch die Anschlußbeschaltungen der Auswahltransistoren N3' und N4'. Im Gegensatz zur Speicherzelle in Figur 1 wird jeweils eine Datenleitung DS zum Schreiben und eine Datenleitung DL zum Lesen eingesetzt. Die Verschaltung der beiden Inverter I1' und I2' wird hierbei wie in der vorhergehenden Speicherzelle vorgenommen. Der Inverter I1' enthält den p-Kanal-Feldeffekttransistor P1' und den n-Kanal-Feldeffekttransistor Nl' und der rückgekoppelte Inverter I2' den p-Kanal-Feldeffekttransistor P2' und den n-Kanal-Feldeffekttransistor N2'. Beide Inverter sind zwischen der Versorgungsspannung VDD und dem Bezugspotential, in diesem Falle Masse, anzuschließen. Der n-Kanal-Auswahltransistor N3' stellt eine Verbindung zwischen der Schreibdatenleitung DS und dem Eingang des ersten Inverters I1' sowie dem Ausgang des rückgekoppelten zweiten Inverters I2' her, und der n-Kanal-Auswahltransistor N4' verbindet die Lesedatenleitung DL mit dem Ausgang des ersten Inverters I1' und dem Eingang des rückgekoppelten Inverters I2'. Der Auswahltransistor N3' zum Einlesen von Informationen in die Speicherzelle ist mit seinem Gateanschluß mit der Schreibwortleitung WS verbunden, während der Auswahltransistor N4', der zum Auslesen von Daten aus der Speicherzelle auf die Lesedatenleitung DL dient mit seinem Gateanschluß mit der Lesewortleitung DL zu verbinden ist.

Das Einschreiben erfolgt in der erfindungsgemäßen 6-Transistor-Speicherzelle von der Schreibdatenleitung DS über den Schreibauswahltransistor N3', der von der Schreibwortleitung WS angesteuert wird. Ausgelesen wird über den Leseauswahltransistor N4', der von einer Lesewortleitung WL angesteuert wird, auf die Lesedatenleitung DL. Von dem aus N1' und P1' gebildeten Inverter I1' wird das Zellsignal über den Leseauswahltransistor N4' auf die Lesedatenleitung DL ausgelesen.

In der erfindungsgemäßen 6-Transistor-Zelle werden beide logischen Zustände der Speicherzelle über die Lesedatenleitung DL ausgelesen. Daher muß der p-Kanal-Transistor P1', im ersten Inverter I1', ausreichend weit dimensioniert werden, um die Lesedatenleitung DL aufladen zu können. Der aus N2' und P2' gebildete Inverter I2' dient hier als Rückkopplung, um die Zellinformation statisch zu erhalten. Diese beiden Feldeffekttransistoren können daher mit einer minimalen Kanalweite und einer minimalen Kanallänge ausgelegt werden. Wegen dieser vorhandenen Asymmetrie der beiden Inverter I1' und I2' wird die Zelle wesentlich störsicherer gegen Informationsverlust beim Auslesen als eine Speicherzelle nach dem Stand der Technik. Ein Vorladen der Lesedatenleitung DL ist bei dieser Speicherzelle nicht erforderlich. Die Kanalweite des Leseauswahltransistors N4' kann im Verhältnis zu dem n-Kanal-Feldeffekttransistor Nl' im ersten Inverter I1' größer gewählt werden als bei der üblichen 6-Transistorzelle, so daß die Lesedatenleitung DL schneller ausgesteuert wird. Durch die Wahl der Kanalweiten von N1', P1' und N4' kann die Geschwindigkeit beim Auslesen der Speicherzelle gegen den benötigten Flächenbedarf eingetauscht werden. Solange die Kapazität der Datenleitung DL nicht zu groß wird, wie dies besonders bei kleinen Speichern oder Speichern mit hierarchischer Architektur auftritt, kann dadurch eine kürzere Lesezugriffszeit erzielt werden. Da hierbei ein Vorladen der Lesedatenleitung nicht erforderlich ist muß auch keine Vorladezeit als Teil der Zykluszeit beim Ein- und Auslesen berücksichtigt werden.

Zum Erkennen des Zellsignals ist in der Speicherzelle nach Figur 2 kein aufwendiger und störanfälliger Leseverstärker notwendig, denn ein Inverter oder eine einfache einstufige Komparatorschaltung sind bei der Auswertung des Zellaignals ausreichend. Hierdurch wird wiederum die Störsicherheit gegen Technologieschwankungen erhöht und die Möglichkeiten beim Umsetzen auf maßstäblich verkleinerte Geometrien (Shrink) verbessert. Durch die einfacherere Leseschaltung, die keinen analogen Differenzverstärker mehr erfordert, kann weiterhin die benötigte Chipfläche verringert werden, wodurch wiederum ein kompakterer Aufbau möglich wird. Da das Einschreiben von der Schreibdatenleitung DS über einen n-Kanal-Transistor N3' erfolgt, steht an dem Speicherknoten 1 für das Einschreiben eines high-Signals nur die Spannung VDD - VT' zur Verfügung, wobei VT' die Einsatzspannung des n-Kanal-Feldeffekttransistors bei der Substratvorspannung VDD - VT' ist. Deshalb ist es günstig, die Schaltschwelle des Inverters I1' auf eine niedere Spannung als VDD/2 zu legen, was beispielsweise durch die Dimensionierung der gleichen Kanalweiten für N1' und P1' möglich ist. Die Schreibdatenleitung DS muß nach dem Schreiben nicht auf einen definierten Pegel umgeladen werden. Daher muß auch keine Schreiberholzeit innerhalb der Schreibzykluszeit eingehalten werden.

Figur 3 zeigt eine weitere erfindungsgemäße Ausführung einer Speicherzelle mit getrennten Schreib- und Lesewortleitungen WS, WL sowie Schreib- und Lesedatenleitungen DS und DL. In der grundsätzlichen Verschaltung entspricht die Speicherzelle nach Figur 3 der in Figur 2, so daß hierbei gleiche Bezugszeichen Verwendung finden. Zusätzlich wird in der Speicherzelle nach Figur 3 zwischen dem Speicherknoten 2 und dem Leseauswahltransistor N4' ein Inverter I5' eingefügt. Dieser enthält einen p-Kanal-Feldeffekttransistor P5' und einen n-Kanal-Feldeffekttransistor N5', wobei ein erster Anschluß von P5' mit der Versorgungsspannung VDD, ein erster Anschluß von N5' mit dem Bezugspotential, in diesem Falle Masse, verschaltet ist und der Eingang des Inverters I5' aus den beiden Gateanschlüssen von P5' und N5' und der Ausgang desselbigen Inverters jeweils durch den zweiten Anschluß von P5' und N5' gebildet wird. Durch diesen zusätzlichen Inverter I5' wird beim Lesen das gespeicherte Zellsignal bereits in der Speicherzelle verstärkt. Zudem kann die Kanalweite des Auswahltransistors N4′ ohne Rücksicht auf die Störsicherheit der Speicherzelle gewählt werden, da die Lesedatenleitung DL vom Speicherknoten 2 entkoppelt ist. Die Kanalweiten von N1' und P1' im ersten Inverter I1' brauchen nur mit Rücksicht auf die Schaltschwelle beim Einschreiben gewählt werden. Sie sind daher möglichst klein zu dimensionieren. Mit dieser Speicherzelle sind besonders kurze Lese- und Schreibzeiten erzielbar.

Als Dimensionierungsbeispiel kann in der Speicherzelle nach Figur 3 zum Einlesen der Inverter I1' so gewählt werden, daß die Kanalweite des p-Kanal-Feldeffekttransistors P1' der Kanalweite des n-Kanal-Feldeffekttransistors N1' entspricht, so daß die Schaltschwelle des Inverters I1' niedriger als die Hälfte der Versorgungsspannung VDD/2 ist. Der n-Kanal-Feldeffekttransistor N5' sollte eine doppelte Kanalweite vom p-Kanal-Feldeffekttransistor P5' besitzen, wobei die Kanalweite des p-Kanal-Feldeffekttransistors P5' ungefähr dreimal der des p- und n-Kanal-Kanal-Feldeffekttransistors P1' und N1' entsprechen sollte. Hierdurch wird ein störungsfreies Auslesen der Daten aus der Speicherzelle gewährleistet.

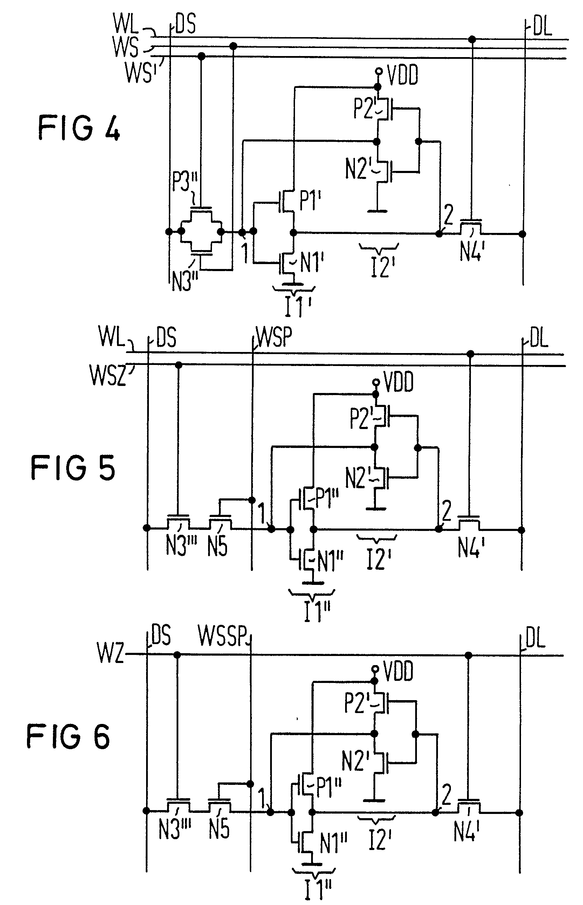

Figur 4 zeigt eine erfindungsgemäße 7-Transistor-Speicherzelle mit CMOS-Transfergatter als Schreibauswahlschaltung. In der grundsätzlichen Verschaltung entspricht diese Speicherzelle der in Figur 2 so daß der Inverter I1' und I2' sowie der Auswahltransistor N4' wie dort zu verschalten ist. Besonders in Technologien mit hoher Substratsteuerung wird das Einschreiben schneller und störsicherer, wenn der Schreibauswahltransistor N3" durch eine Parallelschaltung eines p-Kanal-Feldeffekttransistors P3" zu einem CMOS-Transfergatter erweitert wird. Dann ist eine weitere Schreibwortleitung WS' mit dem invertierten Schreibwortleitungssignal erforderlich. Der Gateanschluß des n-Kanal-Auswahltransistors N3" ist somit mit der Schreibwortleitung WS und der Gateanschluß des p-Kanal-Auswahltransistors P3" mit der Schreibwortleitung WS' beschaltet. Es genügt hierbei, wenn die Schreibwortleitung WS' beim Einlesen von Daten in die Speicherzelle etwas später aktiviert wird als die Schreibwortleitung WS. Daher kann für die Schreibwortleitung WS' eine hochohmigere Leitungsführung gewählt werden als für die Schreibwortleitung WS, ohne daß sich dadurch die Einschaltzeit in die Speicherzelle verlängert.

Figur 5 zeigt eine erfindungsgemäße 7-Transistor-Speicherzelle mit zwei Schreibauswahltransistoren und drei Wortleitungen. Ebenso wie in den vorhergehenden Figuren entspricht die grundsätzliche Verschaltung des ersten und zweiten Inverters I1", I2" und des Auswahltransistors N4' der in Figur 2. Gleiche Bezugszeichen finden auch hier Verwendung. Die Schreibwortleitungen WSZ und WSP sorgen für das Einschreiben von Informationen genau bei der betreffenden Speicherzelle. Um zu verhindern, daß die Schreibdatenleitung DL nicht vor jedem Einschreiben auf ein wohldefiniertes Potential geladen werden muß, muß bei den Speicherzellen nach Figur 2 bis Figur 4 die Dimensionierung des zum Einlesen benötigten n-Kanal-Auswahltransistors, sowie der Transistoren im ersten Inverter so gewählt werden, daß nicht beim Beschreiben einer anderen Speicherzelle an derselben Schreibwortleitung durch Ladungsübertrag der Zellzustand verändert werden kann. Die optimale Dimensionierung ist technologieabhängig und verlangsamt das Beschreiben der Zelle. Generell beschränkt die Forderung nach Stabilität der Zelle gegen Übertrag der Ladung einer abgeschalteten Datenleitung die Anzahl der Speicherzellen-Zeilen im Zellenfeld.

Diese Nachteile treten in der Speicherzelle nach Figur 5 nicht auf. Sie wird über zwei in Serie geschaltete n-Kanal-Schreibauswahltransistoren N3‴und N5 ausgewählt. Der Schreibauswahltransistor N3‴ wird von einer Zeilenschreibwortleitung WSZ angesteuert, die wie die Schreibwortleitung in den Speicherzellen nach Figur 2 bis Figur 4 angeordnet ist und eine Zeile von Speicherzellen zum Schreiben auswählt. Der Schreibauswahltransistor N5 wird von einer senkrecht dazu geführten Spaltenwortleitung WSP angewählt. Hierdurch wird immer nur bei einer einzigen Zelle bzw. für eine Speicherorganisation mit der Wortbreite n bei n-Speicherzellen der Speicherknoten 1 mit einer Schreibdatenleitung DS verbunden. Da die Speicherzelle durch die Zeilenschreibwortleitung WSZ nur beim Schreiben mit der Schreibdatenleitung DS verbunden wird, muß die Spaltenwortleitung WSP nicht mit der Schreib-Leseauswahl verknüpft werden. Durch die bereits beschriebene asymmetrische Auslegung der Inverter I˝ und I2′ ist die Speicherzelle nach Figur 5 beim Lesen und Schreiben gegen Ladungsübertrag von den Datenleitungen unempfindlich. Die Dimensionierung kann daher zur Erzielung einer kurzen Zugriffszeit optimiert werden. Man wählt die beiden in Serie geschalteten Transistoren möglichst groß, um einen möglichst geringen Serienkanalwiderstand zu erzielen.

Die beiden Transistoren im Inverter I1˝ werden gleich dimensioniert, um die Schaltschwelle an die Pegel am Knoten 1 (VDD-VT′, Masse) anzupassen. Neben dem Flächenbedarf beschränken die kapazitiven Belastungen der Datenleitung DS die Weite von N3' und N5. Eine typische Dimensionierung wäre: W (N3') : W (N5) : W (N1") : W (P1') = 5 : 5 : 3 : 3. In I2" sind die Transistorweiten minimal, allerdings wird die Kanallänge von N2' doppelt so groß gewählt wie die von P2', um die gleiche Schaltschwelle wie in Il" zu erzielen. Mit dieser Speicherzelle kann das Umsetzen auf maßstäblich verkleinerte Geometrien (Shrink) problemlos durchgeführt werden und auch bei einer Reduktion der Versorgungsspannung ist die Funktion der Speicherzelle sichergestellt. Dem erhöhten Aufwand für die Führung der zusätzlichen Spaltenwortleitung WSP stehen Einsparungen in der Spaltendekodierung gegenüber.

Figur 6 zeigt eine erfindungsgemäße 7-Transistor-Speicherzelle mit zwei in Serie geschalteten Schreibauswahltransistoren N3‴ und N5′ und zwei Wortleitungen WZ und WSSP. Es handelt sich hierbei um eine erfindungsgemäße Abwandlung der Speicherzelle nach Figur 5, bei der nur eine Zeilenwortleitung WZ zum Schreiben und Lesen benötigt wird. Um die Speicherzelle beim Lesen gegen ein unbeabsichtigtes Überschreiben zu schützen, muß hier die Spaltenwortleitung mit der Schreibauswahl verknüpft, das heißt als Spaltenschreibwortleitung WSSP ausgeführt werden. Somit wird der Schaltungsaufwand in der Zeilendekodierung gegen den Aufwand in der Spaltendekodierung eingetauscht. Durch den Wegfall einer Leitung wird die Zellfläche kleiner, so daß ein kompakterer Aufbau der Speicherzelle möglich wird. Die einzelne Zeilenwortleitung WZ ist mit der doppelten Anzahl von Auswahltransistorgates belastet, denn die Gateanschlüsse des Auswahltransistors N3‴ zum Einlesen und der Gateanschluß des Auswahltransistors N4′ zum Auslesen der Speicherzelle sind jeweils mit der Zeilenwortleitung WZ zu verbinden. In der weiteren grundsätzlichen Verschaltung entspricht die Speicherzelle nach Figur 6 der in Figur 5 wobei wiederum gleiche Bezugszeichen Verwendung finden. Die Auswahl zwischen den Speicherzellen aus Figur 5 und Figur 6 wird im Einzelfall aus den sich ergebenden Unterschieden im bezug auf Laufzeit und der erforderlichen Fläche für die Speicherzelle zu treffen sein.

## Patentansprüche

1. Statische Speicherzelle mit zwei n-Kanal-Transfertransistoren (N3', N4'), zwei Invertern (I1', I2'), zwei Datenleitungen (DS, DL) und mindestens einer ersten Wortleitung (WS), wobei ein erster Anschluß des ersten n-Kanal-Transfertransistors (N3') mit der ersten Datenleitung (DS), ein erster Anschluß des zweiten n-Kanal-Transfertransistors (N4') mit der zweiten Datenleitung (DL), ein Eingang des ersten Inverters (I1') mit einem zweiten Anschluß des ersten n-Kanal-Transfertransistors (N3') und ein Ausgang des ersten Inverters (I1') mit einem zweiten Anschluß des zweiten n-Kanal-Transfertransistors (N4') verschaltet ist, bei der ein Eingang des zweiten Inverters (I2') mit dem Ausgang des ersten Inverters (I1') verbunden ist und ein Ausgang des zweiten Inverters (I2') auf dem Eingang des ersten Inverters (I1') rückgekoppelt ist, bei der ein Gateanschluß des ersten n-Kanal-Transfertransistors (N3') an die erste Wortleitung (WS) angeschlossen ist, bei der ein Gateanschluß des zweiten n-Kanal-Transfertransistors (N4') mit einer zweiten Wortleitung (WL) verschaltet ist, bei der die erste Wortleitung (WS) eine Schreibwortleitung zum Aktivieren des ersten n-Kanal-Transfertransistors (N3') beim Schreibvorgang und die zweite Wortleitung (WL) eine Lesewortleitung zum Aktivieren des zweiten n-Kanal-Transfertransistors (N4') beim Lesevorgang ist, bei der die erste Datenleitung (DS) eine Schreibdatenleitung ist, über die Daten in die Speicherzelle eingeschrieben werden, bei der die zweite Datenleitung (DL) eine Lesedatenleitung ist, über die Daten aus der Speicherzelle ausgelesen werden, bei der erste und zweite Inverter jeweils einen n-Kanal-Feldeffekttransistor (N1', N2', N1") und einen p-Kanal-Feldeffekttransistor (P1', P2',P1") enthält, bei der ein Gateanschluß des n-Kanal-Feldeffekttransistors und ein Gateanschluß des p-Kanal-Feldeffekttransistors gemeinsam einen Eingang des jeweiligen Inverters und ein erster Anschluß des n-Kanal-Feldeffekttransistors und ein erster Anschluß des P-Kanal-Feldeffekttransistors gemeinsam einen Ausgang des jeweiligen Inverters bilden, bei der ein zweiter Anschluß des n-Kanal-Feldeffekttransistors mit einem ersten Anschlußpunkt für ein Massepotential und ein zweiter Anschluß des p-Kanal-Feldeffekttransistors mit einem Anschlußpunkt für eine Versorgungsspannung (VDD) verbunden sind,
**dadurch gekennzeichnet ,**
- daß der erste Inverter (I1') dadurch eine asymmetrische Schaltschwelle ungleich der Hälfte der Versorgungsspannung (VDD) aufweist, daß die Kanalweite des n-Kanal-Feldeffekttransistors (N1', N1") des ersten Inverters und die Kanalweite des p-Kanal-Feldeffekttransistors (P1, P1") des ersten Inverters (I1', I1") gleich groß ist und daß die Kanallänge des n-Kanal-Feldeffekttransistors (N1', N1") und die Kanallänge des p-Kanal-Feldeffekttransistors (P1, P1") des ersten Inverters (I1, I1") gleich groß ist und
- daß der zweite Inverter (12') dadurch eine asymmetrische Schaltschwelle ungleich der Hälfte der Versorgungsspannung (VDD) aufweist, daß die Kanalweite des n-Kanal-Feldeffekttransistors (N2') des zweiten Inverters und die Kanalweite des p-Kanal-Feldeffekttransistors (P2') des zweiten Inverters (I2') gleich groß ist und daß die Kanallänge des n-Kanal-Feldeffekttransistors (N2') im zweiten Inverter (I2') ungefähr doppelt so groß dimensioniert ist wie die gewählte Kanallänge des p-Kanal-Feldeffekttransistors (P2') im zweiten Inverter (I2').

2. Statische Speicherzelle nach Anspruch 1, **dadurch** **gekennzeichnet** , daß ein dritter Inverter (I5') zwischen dem ersten Inverter (I1') und dem zweiten Transfertransistor (N4') geschaltet ist, wobei ein Eingang des dritten Inverters (I5') mit dem Ausgang des ersten Inverters (I1') und ein Ausgang des dritten Inverters (15') mit dem zweiten Anschluß des zweiten Transfertransistors (N4') verbunden ist.

3. Statische Speicherzelle nach Anspruch 1, **dadurch** **gekennzeichnet** , daß der erste Transfertransistor (N3") eines ersten Leitungstyps durch einen parallel geschalteten dritten Transfertransistor (P3") eines zweiten Leitungstyps zu einem Transfergatter ausgebildet ist, daß ein Gateanschluß des dritten Transfertransistors (P3") mit einer dritten Wortleitung (WS') verschaltet ist, wobei die dritte Wortleitung (WS') eine Schreibwortleitung zum Aktivieren des dritten Transfertransistors (P3") beim Schreibvorgang ist.

4. Statische Speicherzelle nach Anspruch 1, **dadurch** **gekennzeichnet** , daß ein vierter Transfertransistor (N5) eines ersten Leitungstyps zwischen dem ersten Transfertransistor (N3‴) und dem ersten Inverter (I1") geschaltet ist, wobei der zweite Anschluß des ersten Transfertransistors (N3‴) mit einem ersten Anschluß des vierten Transfertransistors (N5) und der Eingang des ersten Inverters (I1") mit einem zweiten Anschluß des vierten Transfertransistors (N5) verbunden ist, daß ein Gateanschluß des vierten Transfertransistors mit einer Spaltenwortleitung (WSP) verbunden ist, wobei die Spaltenwortleitung (WSP) den vierten Transfertransistor (N5) beim Ein- oder Auslesen von Daten in die Speicherzelle aktiviert.

5. Statische Speicherzelle nach Anspruch 1,
**dadurch gekennzeichnet** ,
daß die Kanalweite des zweiten Transfertransistors (N4') wesentlich größer dimensioniert ist als die Kanalweite des n-Kanal-Feldeffekttransistors (N1', N1") im ersten Inverter (I1', I1"), um die Lesedatenleitung schneller aussteuern zu können.

## Claims

1. Static memory cell having two n-channel transfer transistors (N3', N4'), two inverters (I1', I2'), two data lines (DS, DL) and at least one first word line (WS), a first terminal of the first n-channel transfer transistor (N3') being connected to the first data line (DS), a first terminal of the second n-channel transfer transistor (N4') being connected to the second data line (DL), an input of the first inverter (I1') being connected to a second terminal of the first n-channel transfer transistor (N3') and an output of the first inverter (I1') being connected to a second terminal of the second n-channel transfer transistor (N4'), in which cell an input of the second inverter (I2') is connected to the output of the first inverter (I1') and an output of the second inverter (I2') is coupled back to the input of the first inverter (I1'), in which cell a gate terminal of the first n-channel transfer transistor (N3') is connected to the first word line (WS), in which cell a gate terminal of the second n-channel transfer transistor (N4') is connected to a second word line (WL), in which cell the first word line (WS) is a write word line for activating the first n-channel transfer transistor (N3') during the writing operation and the second word line (WL) is a read word line for activating the second n-channel transfer transistor (N4') during the reading operation, in which cell the first data line (DS) is a write data line, via which data are written into the memory cell, in which cell the second data line (DL) is a read data line, via which data are read out from the memory cell, in which cell the first and the second inverter respectively include an n-channel field-effect transistor (N1', N2', N1") and a p-channel field-effect transistor (P1', P2', P1"), in which cell a gate terminal of the n-channel field-effect transistor and a gate terminal of the p-channel field-effect transistor jointly form an input of the respective inverter and a first terminal of the n-channel field-effect transistor and a first terminal of the p-channel field-effect transistor jointly form an output of the respective inverter, in which cell a second terminal of the n-channel field-effect transistor is connected to a first connection point for an earth potential and a second terminal of the p-channel field-effect transistor is connected to a connection point for a supply voltage (VDD), characterized
- in that the first inverter (I1') has as a result an asymmetrical switching threshold unequal to half the supply voltage (VDD) in that the channel width of the n-channel field-effect transistor of the first inverter and the channel width of the p-channel field-effect transistor (P1, P1") of the first inverter (I1", I1") are of equal size and in that the channel length of the n-channel field-effect transistor (N1', N1") and the channel length of the p-channel field-effect transistor (P1, P1") of the first inverter (I1, I1") are of equal size and
- in that the second inverter (I2') as a result has an asymmetrical switching threshold unequal to half the supply voltage (VDD), in that the channel width of the n-channel field-effect transistor (N2') of the second inverter and the channel width of the p-channel field-effect transistor (P2') of the second inverter (I2') are of equal size and in that the channel length of the n-channel field-effect transistor (N2') in the second inverter (I2') is dimensioned such that it is approximately double the chosen channel length of the p-channel field-effect transistor (P2') in the second inverter (I2').

2. Static memory cell according to Claim 1, characterized in that a third inverter (I5') is connected between the first inverter (I1') and the second transfer transistor (N4'), an input of the third inverter (I5') being connected to the output of the first inverter (I1') and an output of the third inverter (I5') being connected to the second terminal of the second transfer transistor (N4').

3. Static memory cell according to Claim 1, characterized in that the first transfer transistor (N3") of a first conductivity type is formed by a parallel-connected third transfer transistor (P3") of a second conductivity type to give a transfer gate, in that a gate terminal of the third transfer transistor (P3") is connected to a third word line (WS'), the third word line (WS') being a write word line for activating the third transfer transistor (P3") during the writing operation.

4. Static memory cell according to Claim 1, characterized in that a fourth transfer transistor (N5) of a first conductivity type is connected between the first transfer transistor (N3‴) and the first inverter (I1"), the second terminal of the first transfer transistor (N3‴) being connected to a first terminal of the fourth transfer transistor (N5) and the input of the first inverter (I1") being connected to a second terminal of the fourth transfer transistor (N5), in that a gate terminal of the fourth transfer transistor is connected to a column word line (WSP), the column word line (WSP) activating the fourth transfer transistor (N5) during the reading in or out of data into or from the memory cell.

5. Static memory cell according to Claim 1, characterized in that the channel width of the second transfer transistor (N4') is dimensioned such that it is significantly larger than the channel width of the n-channel field-effect transistor (N1', N1") in the first inverter (I1', I1"), to be able to drive the read data line faster.

## Revendications

1. Cellule de mémoire statique comportant deux transistors de transfert de voie n (N3', N4'), deux inverseurs (I1', I2'), deux lignes de données (DS, DL) et au moins une première ligne de mots (WS), un premier branchement du premier transistor de transfert de voie n (N3') étant connecté à la première ligne de données (DS), un premier branchement du second transistor de transfert de voie n (N4') étant connecté à la seconde ligne de données (DL), une entrée du premier inverseur (I1') étant connectée à un second branchement du premier transistor de transfert de voie n (N3') et une sortie du premier inverseur (I1') étant connecté à un second branchement du second transistor de transfert de voie n (N4'), dans laquelle une entrée du second inverseur (I2') est reliée à la sortie du premier inverseur (I1') et une sortie du second inverseur (I2') est couplée rétroactivement à l'entrée du premier inverseur (I1'), dans laquelle un branchement de porte du premier transistor de transfert de voie n (N3') est branché à la première ligne de mots (WS), dans laquelle un branchement de porte du second transistor de transfert de voie n (N4') est connecté à une seconde ligne de mots (WL), dans laquelle la première ligne de mots (WS) est une ligne de mots d'écriture pour l'activation du premier transistor de transfert de voie n (N3') lors de l'opération d'écriture et la seconde ligne de mots (WL) est une ligne de mots de lecture pour l'activation du second transistor de transfert de voie n (N4') lors de l'opération de lecture, dans laquelle la première ligne de données (DS) est une ligne de données d'écriture au moyen de laquelle des données sont écrites dans la cellule de mémoire, dans laquelle la seconde ligne de données (DL) est une ligne de données de lecture au moyen de laquelle des données sont lues de la cellule de mémoire, dans laquelle le premier et le second inverseur comprennent un transistor à effet de champ de voie n (N1', N2', N1") et un transistor à effet de champ de voie p (P1', P2', P1") respectivement, dans laquelle un branchement de porte du transistor à effet de champ de voie n et un branchement de porte du transistor à effet de champ de voie p forment ensemble une entrée de l'inverseur correspondant et un premier branchement du transistor à effet de champ de voie n et un premier branchement du transistor à effet de champ de voie p forment ensemble une sortie de l'inverseur correspondant, dans laquelle un second branchement du transistor à effet de champ de voie n est relié à un premier point de raccordement pour un potentiel à la masse et un second raccordement du transistor à effet de champ de voie p est relié à un point de raccordement pour une tension d'alimentation (VDD), **caractérisée en ce que**
- le premier inverseur (I1') présente ainsi un seuil de commutation asymétrique différent de la moitié de la tension d'alimentation (VDD), en ce que la largeur de voie du transistor à effet de champ de voie n (N1', N1") du premier inverseur et la largeur de voie du transistor à effet de champ de canal p (P1, P1") du premier inverseur (I1', I1") sont égales, et en ce que la longueur de voie du transistor à effet de champ de voie n (N1', N1") et la longueur de voie du transistor à effet de champ de voie p (P1, P1") du premier inverseur (I1, I1") sont égales, et
en ce que le second inverseur (I2') présente ainsi un seuil de commutation asymétrique différent de la moitié de la tension d'alimentation (VDD), en ce que la largeur de voie du transistor à effet de champ de voie n (N1', N1") du second inverseur et la largeur de voie du transistor à effet de champ de voie p (P2') du second inverseur (I2') sont égales, et en ce que la longueur de voie du transistor à effet de champ de voie n (N2') dans le second inverseur (I2') est dimensionnée environ deux fois plus grande que la longueur de voie sélectionnée du transistor à effet de champ de voie p (P2') dans le second inverseur (I2').

2. Cellule de mémoire statique selon la revendication 1, **caractérisée** **en ce qu**'un troisième inverseur (I5') est monté entre le premier inverseur (11') et le second transistor de transfert (N4'), une entrée du troisième inverseur (I5') étant reliée à la sortie du premier inverseur (Il') et une sortie du troisième inverseur (I5') étant reliée au second branchement du deuxième transistor de transfert (N4').

3. Cellule de mémoire statique selon la revendication 1, **caractérisée** **en ce que** le premier transistor de transfert (N3") d'un premier type de ligne est conçu comme porte de transfert par un troisième transistor de transfert monté en parallèle (P3") d'un second type de ligne, en ce qu'un branchement de porte du troisième transistor de transfert (P3") est connecté à une troisième ligne de mots (WS'), la troisième ligne de mots (WS') étant une ligne de mots d'écriture pour l'activation du troisième transistor de transfert (P3") lors de l'opération d'écriture.

4. Cellule de mémoire statique selon la revendication 1, **caractérisée** **en ce qu**'un quatrième transistor de transfert (N5) d'un premier type de ligne est monté entre le premier transistor de transfert (N3"') et le premier inverseur (I1"), le second branchement du premier transistor de transfert (N3‴) étant relié à un premier branchement du quatrième transistor de transfert (N5) et l'entrée du premier inverseur (I1") étant reliée à un second branchement du quatrième transistor de transfert (N5), en ce qu'un branchement de porte du quatrième transistor de transfert est relié à une ligne de mots à colonnes (WSP), la ligne de mots à colonnes (WSP) activant le quatrième transistor de transfert (N5) lors de l'écriture ou de la lecture des données dans la cellule de mémoire.

5. Cellule de mémoire statique selon la revendication 1,
**caractérisée en ce que**
la largeur de voie du second transistor de transfert (N4') est dimensionnée sensiblement supérieure à la largeur de voie du transistor à effet de champ (N1', N1") de voie n dans le premier inverseur (I1', I1"), pour pouvoir sélectionner plus rapidement la ligne de données de lecture.
